# EUROPEAN PATENT APPLICATION

(11) **EP 4 302 887 A1**
(43) Date of publication of application: **10.01.2024**
(21) Application number: 21929040.0
(22) Date of filing: 04.03.2021
(51) Int. Cl.: B09B 3/00, B09B 5/00

(54) **METHOD FOR PROCESSING SOLAR CELL MODULE**

(30) Priority: 03.03.2021 JP 2021033955
(71) Applicant: Dowa Eco-System Co., Ltd., Tokyo 101-0021 (JP)
(72) Inventor: MORITA Yoshinori, Tokyo 101-0021 (JP); SASAKI Hisashi, Tokyo 101-0021 (JP); TAHATA Shota, Tokyo 101-0021 (JP); WATANABE Ryoei, Tokyo 101-0021 (JP)
(74) Representative: Müller-Boré & Partner Patentanwälte PartG mbB
(86) International application number: PCT/JP2021/008337
(87) International publication number: WO 2022/185465

(57) **Abstract**

There is provided a treatment method for a solar cell module, including: preparing a solar cell sheet-like structure in which a glass substrate and a frame member are removed from a solar cell module, and including at least: a solar battery cell, a metal pattern wired from the solar battery cell, a plastic-made encapsulant for sealing these, and a plastic-made backsheet provided on one surface of the encapsulant; crushing the solar cell sheet-like structure to form a crushed material containing powder derived from each member; and subjecting the crushed material to electrostatic sorting and wind sorting, and separating the powder according to a type of metal and plastic.

## Description

### Background

### Technical field

The present invention relates to a treatment method for a solar cell module.

### Description of related art

In solar cell power generation, an environmental impact is small due to use of a clean energy of sunlight, so it is attracting attention as a renewable energy source. The solar cell module used for this solar cell power generation includes, for example, a glass substrate, an encapsulant that seals a solar battery cell, a backsheet (so-called back sheet), a metal pattern wired from the solar battery cell, and a frame member provided around the encapsulant.

Until now, solar cell modules have been disposed of after being used for a certain period of time. However, in recent years, there is a demand for recovering valuable metals from a viewpoint of recycling. The valuable metals include copper and silver contained in a metal pattern.

Therefore, for example, Patent Document 1 discloses a method for recovering valuable metals from a solar cell module. Patent Document 1 proposes a method of heating a solar cell module to remove an encapsulant and a backsheet, and then recovering the solar battery cell.

### [Prior art documents]

### [Patent document]

[Patent Document 1] JP-A-2015-71162

### Summary of the invention

### Problem to be solved by the invention

In a recycling process of the solar cell module, along with recovery of valuable metals for the purpose of metal recycling, it is also required to sort and recover a backsheet and an encapsulant comprising different plastic components for the purpose of plastic recycling. In this regard, in the method of Patent Document 1, since the encapsulant and the backsheet are removed together by heat treatment, no consideration is given to recovering and recycling them by sorting.

Further, in the method of Patent Document 1, since heat treatment is required, the treatment process becomes complicated, and it is also difficult to continuously recycle the solar cell module in terms of a cost.

An object of the present invention is to provide a technique of a simple process for recovering valuable metals from a solar cell module and sorting and recovering different plastic components according to a type.

### Means for solving the problem

The present inventors have studied a treatment method that does not involve heat treatment, etc., and focus on a crushing treatment applied to a solar cell sheet-like structure as an object to be treated, which is an intermediate product of a partially disassembled solar cell module. A crushed material obtained by the crushing treatment includes powder derived from a solar battery cell and a metal pattern, plastic powder derived from an encapsulant and a backsheet, etc. These powders differ in weight, chargeability, and conductivity depending on a member from which they are derived. This reveals that in order to separate these powders according to the type of a member, it is effective to subject the crushed material to wind sorting and electrostatic sorting.

The following aspects were created based on the above finding.

Aspect 1 of the present inventio provides a treatment method for a solar cell module, including:
preparing a solar cell sheet-like structure in which a glass substrate and a frame member are removed from a solar cell module, and including at least: a solar battery cell, a metal pattern wired from the solar battery cell, a plastic-made encapsulant for sealing these, and a plastic-made backsheet provided on one surface of the encapsulant;
crushing the solar cell sheet-like structure to form a crushed material containing powder derived from each member; and
subjecting the crushed material to electrostatic sorting and wind sorting, and separating the powder according to a type of metal and plastic.

Aspect 2 of the present invention provides the treatment method for a solar cell module according to aspect 1, wherein in the separation of the powder, the powder contained in the crushed material is separated into heavy weights and other light weights by wind sorting, then, separated into low-insulation powder having a low volume resistivity and high-insulation powder having a relatively high volume resistivity by subjecting the light weights to electrostatic sorting.

Aspect 3 of the present invention provides the treatment method for a solar cell module according to aspect 1, including:
preparing a solar cell sheet-like structure in which a glass substrate and a frame member are removed from a solar cell module, and including at least: a solar battery cell, a metal pattern wired from the solar battery cell, a plastic-made encapsulant for sealing these, and a plastic-made backsheet provided on one surface of the encapsulant;
crushing the solar cell sheet-like structure to form a crushed material containing powder derived from each member; and
separating the crushed material into conductive powder, low-insulation powder with low volume resistivity, and high-insulation powder with relatively high volume resistivity, by electrostatic sorting.

Aspect 4 provides the treatment method for a solar cell module according to aspect 3, wherein after the separation of the crushed material, each of the low-insulation powder and the high-insulation powder is separated into heavy weights and light weights by wind sorting.

Aspect 5 provides the treatment method for a solar cell module according to any one of aspects 1, 2, and 4, wherein in the separation of the crushed material, wind sorting is performed at a wind speed of 5 m/s or more and 20 m/s or less.

Aspect 6 provides the treatment method for a solar cell module according to any one of aspects 1 to 5, wherein the encapsulant contains ethylene-vinyl acetate, and the backsheet contains polyethylene terephthalate.

Aspect 7 provides the treatment method for a solar cell module according to any one of aspects 1 to 6, wherein in the separation of the crushed material, electrostatic sorting is performed with a voltage of 10 kV or more and 30 kV or less applied to an electrode.

Aspect 8 provides the treatment method for a solar cell module according to any one of aspects 1 to 7, wherein in the crushing of the solar cell sheet-like structure, the solar cell sheet-like structure is crushed so that a particle size of the crushed material is 20 mm or less.

### Advantage of the Invention

According to the present invention, valuable metals can be recovered from a solar cell module and different plastic components can be continuously sorted and recovered according to the type in a simple process.

### Brief description of the drawings

FIG. 1 is a schematic cross-sectional image of a solar cell module.
FIG. 2 is a schematic cross-sectional image of a solar cell sheet-like structure.

### Detailed description of the invention

### <One embodiment of the present invention>

Hereinafter, a treatment method for a solar cell module according to an embodiment of the present invention will be described. The treatment method of this embodiment has a preparation step, a crushing step and a separation step. Each step will be described in detail below.

### (Preparation step)

First, a solar cell sheet-like structure (hereinafter also simply referred to as a sheet-like structure) as a treatment object is prepared. The sheet-like structure is the structure in which a glass substrate and a frame member are removed from a solar cell module.

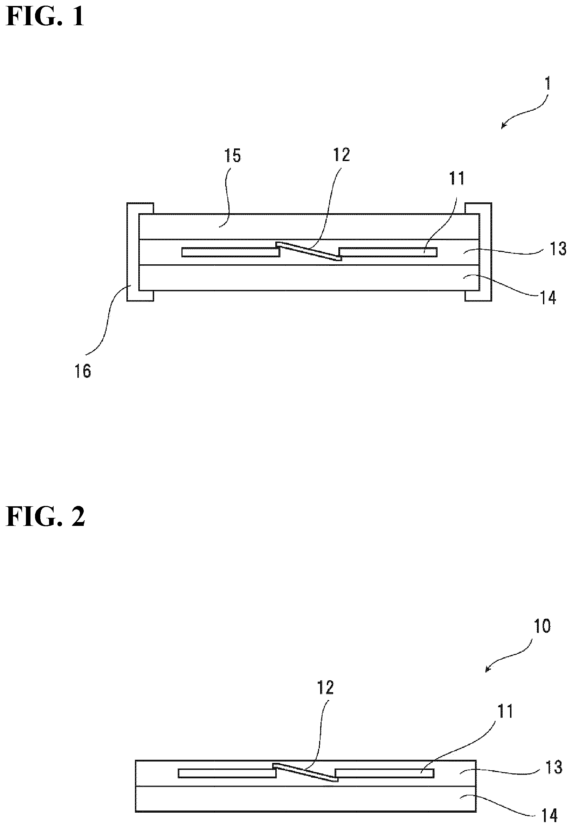

For example, as shown in FIG. 1, a solar cell module 1 includes: a plurality of solar battery cells 11, metal patterns 12 wired from the solar battery cells 11, an encapsulant 13 that seals the solar battery cells 11 and the metal patterns 12, a backsheet 14 provided on one surface of the encapsulant 13, a glass substrate 15 provided on the other surface of the encapsulant 13, and a frame member 16 surrounding a laminate including the encapsulant 13 and the glass substrate 15.

In the solar cell module 1, the solar battery cell 11 comprises a semiconductor containing silicon, for example. The metal pattern 12 is a metal member wired from the solar battery cell 11, and includes for example, a surface electrode provided on the surface of the solar battery cell 11 and a bus bar electrode electrically connecting between solar battery cells 11. The metal pattern 12 contains a valuable metal such as copper (Cu) or silver (Ag), the surface electrode comprises Ag, and the bus bar electrode comprises mainly Cu. The encapsulant 13 comprises plastic such as ethylene-vinyl acetate (EVA) or polyethylene. The backsheet 14 comprises plastic different from that of the encapsulant 13, such as polyethylene terephthalate (PET) or fluoropolymer. The glass substrate 15 comprises glass, for example. The frame member 16 comprises metal, plastic, etc., for example.

The sheet-like structure 10 is configured as shown in FIG. 2, with the glass substrate 15 and the frame member 16 removed from the solar cell module 1, and specifically includes: a solar battery cell 11, a metal pattern 12 wired from the solar battery cell 11, an encapsulant 13 for sealing the solar battery cell 11 and the metal pattern 12, and a backsheet 14 provided on one surface of the encapsulant 13.

A method for removing the glass substrate 15 and the frame member 16 from the solar cell module 1 is not particularly limited, and a known method can be adopted. For removing the glass substrate 15, for example, a hot knife method, a roll crushing method, a shot blasting method, etc., can be used.

### (Crushing step)

Subsequently, the sheet-like structure 10 is crushed. Thereby, a crushed material containing powder derived from each member is obtained. The powders contained in the crushed material include powder containing a semiconductor material derived from the solar battery cell 11, metal powder containing valuable metals derived from the metal pattern 12, plastic powder derived from the encapsulant 13, plastic powder derived from the backsheet 14, etc. In some cases, a portion where the encapsulant 13 and the backsheet 14 are in contact with each other may be crushed, to generate a mixture of powder, etc., to which the plastic of the encapsulant 13 and the plastic of the backsheet 14 are adhered.

In crushing the sheet-like structure 10, for example, a member comprising a soft and sticky material such as plastic tends to be crushed coarsely, and a member comprising a hard and brittle material such as metal or Si tends to be crushed finely. Specifically, the solar battery cell 11 containing silicon and the metal pattern 12 containing valuable metals are easily crushed into small pieces. On the other hand, the encapsulant 13, the backsheet 14, etc., comprising plastic are crushed coarsely because they are soft. That is, each member constituting the sheet-like structure 10 is crushed into powders having different particle sizes depending on the material. According to such a crushed material, each powder can be easily sorted by electrostatic sorting or wind sorting, which will be described later, based on differences in electrification and specific gravities.

The size (particle size) of the crushed material is preferably 20 mm or less, more preferably 15 mm or less, and even more preferably 10 mm or less. By setting the crushed material to such a size, the powder can be easily sorted based on a difference in the specific gravity and a difference in chargeability when wind sorting and electrostatic sorting are performed in a later-described separation step. The size of the crushed material varies depending on a crushing method, but it is preferable to make it as small as possible in consideration of a treatment cost.

From a viewpoint of crushing each member constituting the sheet-like structure 10 so as to have a size corresponding to the material thereof, shear crushing capable of imparting a shearing action to the sheet-like structure 10 is preferable as the crushing method. For example, a known crusher such as a uniaxial crusher or a biaxial crusher can be used as the crusher to be used, but the uniaxial crusher is preferable. Depending on a crushing condition, the biaxial crusher may uniformly and finely crush the material to be crushed, thereby producing a uniform particle size. On the other hand, according to the uniaxial crusher, coarse crushing is carried out, thereby producing a non-uniform particle size in the obtained crushed material, resulting in a wide particle size distribution. Therefore, according to the uniaxial crusher, the solar battery cell 11, the metal pattern 12, the encapsulant 13, and the backsheet 14 are easily crushed into particle sizes corresponding to their materials, without excessively finely crushing the encapsulant 13 and the backsheet 14 comprising plastic. Thereby, the crushed material can be easily sorted for each member in the later-described separation step.

The uniaxial crusher includes a uniaxial cutter mill, a uniaxial hammer mill, etc., depending on a shape of a blade, but the uniaxial cutter mill is preferable from a viewpoint of shearing and crushing.

The crushing conditions are not particularly limited, and the number of blades in the crusher, blade clearance, the number of rotations of the blades, etc., may be appropriately adjusted so that the particle size distribution of the crushed material is widened. Further, the sheet-like structure may be crushed in one step, or may be crushed gradually in multiple steps such as primary crushing and secondary crushing.

### (Separation step)

Subsequently, the powder contained in the crushed material is separated according to a type of metal and plastic. In the present embodiment, the crushed material is subjected to wind sorting and electrostatic sorting. In the following, an example will be described in which the electrostatic sorting is performed after the crushed material is subjected to wind sorting.

### (Wind sorting)

First, the crushed material is subjected to wind sorting. Since the crushed material contains powders of different weights, the crushed material can be separated into heavy weights and lighter weights by blowing air onto the crushed material. Here, powder containing silicon derived from the solar battery cell 11 and metal powder containing valuable metals derived from the metal pattern 12 are collected as the heavy weights. Plastic powder derived from the encapsulant 13 and the backsheet 14 is collected as the lighter weights.

In the wind sorting, a wind speed is not particularly limited, but from a viewpoint of separating the metal powder and the plastic powder, it is preferably 5 m/s or more and 20 m/s or less. By performing wind sorting at such wind speeds, powder containing a large amount of valuable metals can be more reliably separated as the heavy weights and plastic powder can be more reliably separated as the lighter weights. The wind speed refers to the speed of the air hitting the powder.

A wind sorter to be used is not particularly limited, and a known sorter such as a circulation type, an air knife type, a blow-up type, a suction type, and a closed type can be used. From a viewpoint of selectively and efficiently collecting heavy weights, the circulation type, blowing-up type and closed type are preferable. Dry or wet classification (treatment to sort by specific gravity) using gravity, inertial force, centrifugal force, etc., can also be used instead of the wind sorting. However, the wind sorting is preferable from a viewpoint of treatment capacity and cost.

### (Electrostatic sorting)

Next, the light weights obtained by the wind sorting is subjected to electrostatic sorting using an electrostatic sorter. In the present embodiment, due to containing plastic, the light weights are electrified by corona discharge, and thereafter, sorted according to the type of plastic, based on a difference in chargeability and conductivity of the plastic contained in the light weights.

A conventionally known device can be used as the electrostatic sorter. For example, the electrostatic sorter including: a rotatable supported grounded metal drum electrode; a needle-like or blade-like high-voltage electrode provided facing the grounded metal drum electrode; an electrostatic electrode provided downstream of the high-voltage electrode in a direction of rotation of the grounded metal drum electrode and facing the grounded metal drum electrode; a brush that removes powder adhering to the grounded metal drum electrode; and a separation container for separately storing sorted powder, can be used.

In the electrostatic sorter, first, a voltage is applied between the grounded metal drum electrode and the high voltage electrode to generate corona discharge. Subsequently, an object to be sorted (here, the light weights) is fed onto the grounded metal drum electrode and conveyed. The object is conveyed to an area under the high voltage electrode and charged to the same sign as the high voltage electrode. A charged object releases charge to the grounded metal drum at a rate that depends on the conductivity of the object, when leaving an area where gaseous ions are applied during rotation of the grounded metal drum. A conductive object quickly releases charge, becomes electrically neutral, detaches from the grounded metal drum electrode, and drops. When the object has high conductivity, the object is charged with an opposite sign to that of the grounded metal drum, jumps in a rotating direction of the grounded metal drum due to repulsion between the same signs as the grounded metal drum, and drops while being attracted by a high voltage electrostatic electrode installed in a jumping direction. On the other hand, a non-conductive object is less likely to release charge to the grounded metal drum, is attracted to an opposite sign of the grounded metal drum, and rotates with the grounded metal drum in a state of being adhered to the grounded metal drum. The object rotated with the grounded metal drum is physically removed by the brush attached to the grounded metal drum.

Specifically, the light weights mainly include plastic powder derived from the encapsulant 13 and plastic powder derived from the backsheet 14. Since the plastic powder derived from the encapsulant 13 and the plastic powder derived from the backsheet 14 comprise different plastics, they have different volume resistivities, different chargeability, and different conductivity. Therefore, by electrostatically sorting the light weights, the plastic powder derived from the encapsulant 13 and the plastic powder derived from the backsheet 14 can be separated into low-insulation powder with low volume resistivity and high-insulation powder with relatively high volume resistivity, based on a difference in chargeability and a difference in conductivity. That is, the light weights can be separated according to the type of plastic of the encapsulant 13 and the backsheet 14. The powder to which the plastic of the encapsulant 13 and the plastic of the backsheet 14 are adhered, is classified into both low-insulation powder and high-insulation powder. Alternatively, powder having intermediate properties between those of the low-insulation powder and the high-insulation powder may also be sorted and recovered separately from these.

The low-insulation powder and high-insulation powder vary depending on the type of plastic comprised in the encapsulant 13 and backsheet 14. For example, when the encapsulant 13 comprises EVA and the backsheet 14 comprises PET, PET is more easily charged and less conductive than EVA (high insulation). Therefore, the powder derived from the backsheet 14 is separated as a high-insulation powder, and the powder derived from the encapsulant 13 is separated as the low-insulation powder.

The plastic powder that can be electrostatically separated has a volume resistivity of 1.0×10⁸ [Ω·cm] or more and 1.0×10¹⁹ [Ω·cm] or less. Further, from a viewpoint of efficient electrostatic sorting of the low-insulation powder and high-insulation powder, it is preferable that the volume resistivity of the high-insulation powder is 1.0×10³ times or more that of the low-insulation powder. This is because the more the volume resistivities of these powders deviate, the more efficiently the electrostatic sorting can be performed. The volume resistivity of the plastic used for the encapsulant 13 and the backsheet 14 is as follows. EVA is 1.5×10⁸ [Ω • cm], polyethylene is 1.0×10¹⁶ [Ω • cm], PET is 1.0×10¹⁹ [Ω • cm], fluoropolymer is 2.0×10¹⁴ [Ω • cm].

The voltage applied during electrostatic sorting may be set appropriately and is not particularly limited, as long as the plastic powder derived from the encapsulant 13 and the plastic powder derived from the backsheet 14 can be separated into high-insulation powder and low-insulation powder based on the difference in chargeability and conductivity (difference in volume resistivity). The voltage applied between the electrodes is preferably 5 kV or more from a viewpoint of sufficiently generating corona discharge between the electrodes and sufficiently applying electric charge to the object to be sorted. On the other hand, if the applied voltage is excessively high, sparks may occur, and both high-insulation powder and low-insulation powder adhere to the grounded metal drum, which is not preferable from a viewpoint of sorting efficiency. However, a permissible range of a maximum value of the applied voltage fluctuates as a distance between the grounded metal drum and the high-voltage electrode is increased or as the properties and shapes of the objects to be sorted change. In order to sort the powder derived from the plastic comprised in the encapsulant 13 and the backsheet 14, the applied voltage is more preferably 10 kV or more and 30 kV or less.

A distance and installation angle of a needle-like or blade-like high-voltage electrode and the high-voltage electrostatic electrode from the grounded metal drum electrode, and the rotation speed of the grounded metal drum electrode are not particularly limited, and can be changed as appropriate. For example, the rotation speed of the grounded metal drum electrode can be adjusted in a range of 10 rpm to 60 rpm, the distance between the needle-like or blade-like high voltage electrode and the grounded metal drum electrode can be adjusted in a range of 0.5 cm to 5 cm, and the installation angle of the needle-like or blade-like high-voltage electrode and the high-voltage electrostatic electrode can be adjusted in a range of +90 degrees to -90 degrees with a horizontal direction of the grounded metal drum as a reference of the axis. In performing this electrostatic sorting, with the voltage applied to the electrodes set at 10 kV or more and 30 kV or less, the rotation speed of the rotating drum electrode may be adjusted in a range of 10 rpm to 30 rpm, the distance between the needle-like or blade-like high-voltage electrode and the grounded metal drum electrode may be adjusted in a range of 1 cm to 2 cm, the distance between the high-voltage electrostatic electrode and the grounded metal drum may be adjusted in a range of 5 cm to 10 cm, the installation angle of the needle-like or blade-like high-voltage electrode may be adjusted in a range of +40° to +50° with the horizontal direction of the grounded metal drum as a reference of the axis, and the installation angle of the high-voltage electrostatic electrode may be adjusted in a range of 0 to +30° with the horizontal direction of the grounded metal drum as a reference of the axis. When the voltage applied to the electrodes is changed, each optimum condition is also changed.

Further, electrostatic sorting may be performed not only once but also multiple times. For example, the low-insulation powder and the high-insulation powder obtained by electrostatic sorting may also be subjected to electrostatic sorting respectively one by one. When performing the electrostatic sorting multiple times, multiple separation containers installed at a bottom of the electrostatic sorter are used. The powder after electrostatic sorting can be recovered by using a separation container for recovering powder that jumps from the grounded metal drum electrode and drops while being attracted to the high-voltage electrostatic electrode; a separation container for recovering powder that detaches and drops from the grounded metal drum electrode; and a separation container for recovering powder by rotating with the grounded metal drum while being adhered to the grounded metal drum electrode and physically removing and dropping the powder by a brush attached to the grounded metal drum. It is also possible to install another separation container between the separation container for recovering powder that detaches and drops from the grounded metal drum electrode and the separation container for recovering powder that is physically removed and dropped by the brush attached to the grounded metal drum, and recover powder to which the plastic of the encapsulant 13 and the plastic of the backsheet 14 are adhered, the powder being classified into both non-conductive powder that is easily charged and conductive powder that is difficult to be charged.

As described above, the valuable metals contained in the solar cell module 1, the plastic comprised in the encapsulant 13, and the plastic comprised in the backsheet 14 can be sorted and recovered according to the type.

### <Effects of the present embodiment>

According to the present embodiment, one or more of the following effects can be obtained.

In the present embodiment, the sheet-like structure 10 from which the glass substrate 15 and the frame member 16 have been removed is crushed, and the crushed material is subjected to wind sorting and electrostatic sorting. First, by using the sheet-like structure 10 as the object to be treated, the components derived from the glass substrate 15 and the frame member 16 are separated. Subsequently, by subjecting the crushed material to wind sorting, silicon derived from the solar cell 11 and valuable metals derived from the metal pattern 12 can be recovered as heavy weights. Further, by electrostatically sorting the light weights obtained by wind sorting, at least the plastic powder derived from the encapsulant 13 and the plastic powder derived from the backsheet 14 can be separated as the low-insulation and high-insulation powders based on the difference in chargeability and conductivity. Thus, according to the treatment method of the present embodiment, the valuable metals can be recovered from the solar cell module 1, and the encapsulant 13 and the backsheet 14 can be sorted and recovered.

Further, according to the present embodiment, valuable metals and plastic can be mechanically separated by crushing the sheet-like structure 10 and subjecting the crushed material to wind sorting or electrostatic sorting. Therefore, the process can be simplified compared to a treatment method using heat treatment or chemical treatment. In addition, since crushing, wind sorting, and electrostatic sorting can be performed continuously, a large amount of sheet-like structures 10 can be treated continuously and efficiently.

Further, the voltage applied in the electrostatic sorting is preferably 10 kV or more and 30 kV or less. Within this voltage range, generation of sparks due to excessive applied voltage can be suppressed while generating corona discharge. In addition, low-insulation powder and high-insulation powder can be preferably separated when light weights are subjected to electrostatic sorting. Further, with such an applied voltage, it is possible to more reliably separate plastic powder containing EVA as low-insulating powder and plastic powder containing PET as high-insulating powder.

Further, it is preferable to set the wind speed of the wind blowing against the crushed material in the wind sorting, to 5 m/s or more and 20 m/s or less. With such a wind speed, heavy weights containing valuable metals and light weights containing plastic derived from the encapsulant 13 and the backsheet 14 can be more reliably separated.

Further, the sheet-like structure 10 is preferably crushed so that the particle size of the crushed material is 20 mm or less. With such a particle size, powders can be more reliably separated based on the difference in specific gravity, chargeability and conductivity during wind sorting or electrostatic sorting.

### <Other embodiments>

As described above, the embodiments of the present invention have been specifically explained. However, the present invention is not limited to the above-described embodiments, and various modifications can be made without departing from the scope of the invention.

The above-described embodiment shows a case that the solar cell sheet-like structure 10 includes the encapsulant 13 and the backsheet 14, and includes two types of plastic. However, other plastic member may be included. For example, in some cases, the backsheet 14 does not comprise a single plastic but is constructed by laminating two or more plastic layers, and three or more plastic powders are mixed in the crushed material. In such a case, in order to sort three or more types of plastics contained in the crushed material, electrostatic sorting may be performed twice or more by appropriately changing the electrostatic sorting conditions such as the voltage to be applied.

Further, the above-described embodiment shows a case that wind sorting is performed first and thereafter electrostatic sorting is performed as the separation step, but the present invention is not limited to the order or sorting steps. For example, the crushed material may be electrostatically sorted after crushing. Preferably, wind sorting may be performed to each of the powders separated by electrostatic sorting. This point will be specifically described below.

The crushed material contains the mixture of the powders derived from the solar battery cell 11, metal pattern 12, encapsulant 13, and backsheet 14, as described above. The crushed material is electrostatically sorted by setting the voltage between the electrodes so that at least the plastic powder derived from the encapsulant 13 and the plastic powder derived from the backsheet 14 can be separated. Thereby, first, due to particularly high conductivity, the powder group derived from the solar cell 11 and the metal pattern 12 jumps from the grounded metal drum electrode, drops while being attracted to the electrostatic electrode, and is separated. Subsequently, among the powder group containing the plastic powder derived from the encapsulant 13 and the powder group containing the plastic powder derived from the backsheet 14, those having relatively high conductivity and low insulation are separated as the low-insulation powder.

Finally, the high insulation will be separated as the high insulation powder. Specifically, when the encapsulant 13 comprises EVA and the backsheet 14 comprises PET, first, the metal powder is separated, then the plastic powder derived from the encapsulant 13 is separated as the low-insulation powder, and finally the plastic powder derived from the backsheet 14 is separated as the high-insulation powder. Thus, by electrostatically sorting the crushed material, the conductive powder, the low-insulation powder, and the high-insulation powder can be separated.

Subsequently, the low-insulation powder and the high-insulation powder separated by electrostatic sorting are preferably subjected to wind sorting. This is because the powders derived from the solar cell 11 and the metal pattern 12 are separated by the above-described electrostatic sorting, but may be mixed with the low-insulation powder and the high-insulation powder in some cases. By subjecting each of the low-insulation powder and the high-insulation powder to wind sorting, the powder derived from the metal pattern 12 can be separated as the heavy weights and the powder comprising plastic can be separated as the light weights. As described above, as in the above-described embodiment, the encapsulant 13 and the backsheet 14 can be sorted and recovered while recovering the valuable metals.

### Examples

Next, the present invention will be described in more detail based on examples, but the present invention is not limited to these examples.

### (Example 1)

As an object to be treated, a solar cell sheet-like structure (PV sheet) was prepared by removing the glass substrate and the frame member from the solar cell module. In the PV sheet, the encapsulant comprises EVA, and the backsheet comprises PET. Subsequently, a nugget machine was used to crush the PV sheet. At this time, crushing was performed until the crushed material passed through a 3 mm screen, and when it did not pass, the treatment was repeated. A uniaxial cutter mill "SKC-25-540L" was used as the nugget machine. As crushing conditions, the number of blades was adjusted to 45, the clearance was about 2 mm, and the rotation speed of the blades was adjusted to 630 rpm. Further, "APS-250RB" was used as the wind sorter.

Subsequently, the crushed PV sheet with a particle size of 3 mm or less was subjected to wind sorting at a wind speed of 20 m/s. Thereby, heavy weights and light weights were separated. Valuable metals and powder derived from the solar battery cell were mainly contained in the heavy weights. EVA powder (black) derived from the encapsulant, PET powder (white) derived from the backsheet, etc., were contained in the light weights.

Subsequently, electrostatic sorting was performed to the light weights containing plastic powder. Specifically, electrostatic sorting was performed using an electrostatic sorter, under conditions of an applied voltage of 19 kV and a drum rotation speed of 20 rpm. Thereby, first, by detaching the EVA powder from the grounded metal drum electrode and dropping it as a conductive powder that is difficult to be charged, that is, a low-insulating powder, the EVA powder was separated and recovered in a separation container installed below the grounded metal drum electrode. Subsequently, easily charged non-conductive powder, that is, PET powder as high-insulation powder was rotated together with the grounded metal drum while being adhered to the grounded metal drum, physically removed by a brush attached to the grounded metal drum, and separated and recovered in a separation container installed below the brush. Further, the powder recovered in each separation container was subjected to electrostatic sorting three times to collect low-insulation powder and high-insulation powder.

In order to confirm that the plastic can be separated according to the type in this example, the following evaluation was performed. Specifically, for each of the light weights before electrostatic sorting, the sample that dropped from the grounded metal drum electrode, and the sample that adhered to the grounded metal drum electrode and was recovered by the brush when the light weights were subjected to the electrostatic sorting, the proportion of the EVA powder, which is low-insulation powder, and PET powder, which is high-insulation powder, was obtained. This proportion was calculated from an area proportion of each region by performing image analysis for each sample, with white PET powder regarded as a white region and black EVA powder regarded as a black region.

As a result, it was confirmed that PET powder was present at a proportion of 6% and EVA powder was present at a proportion of 94% per unit area in the light weights before electrostatic sorting. It was also confirmed that PET powder was present at a proportion of 1% and EVA powder was present at a proportion of 99% per unit area in the dropped sample. It was also confirmed that PET powder was present at a proportion of 8% and EVA powder was present at a proportion of 92% per unit area in the adhered sample. In addition, it was also confirmed that the PET powder could be efficiently separated as the high-insulation powder, because the proportion of PET powder could be as low as 1% in the drop sample and as high as 8% in the adhered sample, and the PET powder could be concentrated by making the proportion in the adhered sample higher than the proportion (6%) contained in the light weights before electrostatic sorting.

### Description of signs and numerals

- 1: Solar cell module
- 10: Solar cell sheet-like structure
- 11: Solar battery cell
- 12: Metal pattern
- 13: Encapsulant
- 14: Backsheet
- 15: Glass substrate
- 16: Frame member

## Claims

1. A treatment method for a solar cell module, including:
preparing a solar cell sheet-like structure in which a glass substrate and a frame member are removed from a solar cell module, and including at least: a solar battery cell, a metal pattern wired from the solar battery cell, a plastic-made encapsulant for sealing these, and a plastic-made backsheet provided on one surface of the encapsulant;
crushing the solar cell sheet-like structure to form a crushed material containing powder derived from each member; and
subjecting the crushed material to electrostatic sorting and wind sorting, and separating the powder according to a type of metal and plastic.

2. The treatment method for a solar cell module according to claim 1, wherein in the separation of the powder, the powder contained in the crushed material is separated into heavy weights and other light weights by wind sorting, then, separated into low-insulation powder having a low volume resistivity and high-insulation powder having a relatively high volume resistivity by subjecting the light weights to electrostatic sorting.

3. The treatment method for a solar cell module according to claim 1, including:
preparing a solar cell sheet-like structure in which a glass substrate and a frame member are removed from a solar cell module, and including at least: a solar battery cell, a metal pattern wired from the solar battery cell, a plastic-made encapsulant for sealing these, and a plastic-made backsheet provided on one surface of the encapsulant;
crushing the solar cell sheet-like structure to form a crushed material containing powder derived from each member; and
separating the crushed material into conductive powder, low-insulation powder with low volume resistivity, and high-insulation powder with relatively high volume resistivity, by electrostatic sorting.

4. The treatment method for a solar cell module according to claim 3, wherein after the separation of the crushed material, each of the low-insulation powder and the high-insulation powder is separated into heavy weights and light weights by wind sorting.

5. The treatment method for a solar cell module according to any one of claims 1, 2, and 4, wherein in the separation of the crushed material, wind sorting is performed at a wind speed of 5 m/s or more and 20 m/s or less.

6. The treatment method for a solar cell module according to any one of claims 1 to 5, wherein the encapsulant contains ethylene-vinyl acetate, and the backsheet contains polyethylene terephthalate.

7. The treatment method for a solar cell module according to any one of claims 1 to 6, wherein in the separation of the crushed material, electrostatic sorting is performed with a voltage of 10 kV or more and 30 kV or less applied to an electrode.

8. The treatment method for a solar cell module according to any one of claims 1 to 7, wherein in the crushing of the solar cell sheet-like structure, the solar cell sheet-like structure is crushed so that a particle size of the crushed material is 20 mm or less.
